(19) **Europäisches Patentamt / European Patent Office / Office européen des brevets**

(11) **EP 4 621 428 A1**

(12) # EUROPEAN PATENT APPLICATION
published in accordance with Art. 153(4) EPC

(43) Date of publication:
**24.09.2025 Bulletin 2025/39**

(21) Application number: **23907555.9**

(22) Date of filing: **12.12.2023**

(51) International Patent Classification (IPC):
*G01R 31/392* (2019.01)   *G01R 31/374* (2019.01)
*G01R 31/385* (2019.01)   *G01R 19/00* (2006.01)
*G01R 19/165* (2006.01)   *G01R 31/52* (2020.01)
*G01R 19/10* (2006.01)   *G01R 31/396* (2019.01)
*B60R 16/033* (2006.01)

(52) Cooperative Patent Classification (CPC):
**H01M 10/425; H01M 10/482; H01M 2010/4271**

(86) International application number:
**PCT/KR2023/020464**

(87) International publication number:
**WO 2024/136269 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.12.2022   KR 20220182381**
**11.04.2023   KR 20230047829**
**01.12.2023   KR 20230172718**

(71) Applicant: **LG Energy Solution, Ltd.**
**Seoul 07335 (KR)**

(72) Inventors:
• **LEE, Sun Jong**
  **Daejeon 34122 (KR)**
• **KIM, Cheol Taek**
  **Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND OPERATION METHOD THEREFOR**

(57)   A battery management system includes: a voltmeter configured to measure a voltage of each of a plurality of battery banks; and a controller. Based on a first value, which is a variation amount of voltage of each of the plurality of battery banks during a predetermined time interval, and a second value, which is a standard deviation of a voltage variation amount per unit time for each of the plurality of battery banks, the controller selects the first value of each of the plurality of battery banks. Then, the controller ranks the plurality of battery banks based on a first reference value, which represents a ratio of the selected first value of each of the plurality of battery banks to an average value of the selected first value of each of the plurality of battery banks; and diagnoses at least one abnormal battery bank among the plurality of battery banks based on ranks of the plurality of battery banks at a designated time point.

FIG.2

Description

[TECHNICAL FIELD]

CROSS-REFERENCE TO RELATED APPLICATION

This application claims priority to and the benefit of Korean Patent Application No. 10-2023-0172718 filed in the Korean Intellectual Property Office on December 1, 2023, Korean Patent Application No. 10-2023-0047829 filed in the Korean Intellectual Property Office on April 11, 2023, and Korean Patent Application No. 10-2022-0182381 filed in the Korean Intellectual Property Office on December 22, 2022, the entire contents of which are incorporated herein by reference.

TECHNICAL FIELD

The present disclosure relates to a battery management system, an operation method thereof, and a storage medium.

[BACKGROUND ART]

Electric vehicles draw their vitality from external power sources to replenish their batteries, infusing them with the energy required for driving power. Over time, as these batteries undergo the cycles of charge and discharge throughout their stages of manufacturing and use, internal deformation and degeneration will take place. Consequently, this process can alter their physical and chemical properties, potentially resulting in defects. For instance, reduction of lithium ions from the battery's anode may not properly occur at the cathode, leading to the formation of lithium deposits, also known as dendrites, on the surface of the cathode.
As the accumulation of these lithium deposits continues, the risk of internal short between the cathode and the anode of the battery increases. Such an internal short can result in adverse effects, including undervoltage faults where the voltage drops below a certain threshold, or even the potential for ignition.

[DISCLOSURE]

[TECHNICAL PROBLEM]

Embodiments disclosed herein aim to provide a battery management system and an operation method thereof, which are capable of accurately diagnosing an abnormal battery bank using voltage behaviors of battery banks during a relaxation time.

[TECHNICAL SOLUTION]

According to some embodiments, a battery management system comprises: a voltmeter configured to measure a voltage of each of a plurality of battery banks; and a controller in communication with the voltmeter and configured to: based on a first value, which is a variation amount of voltage of each of the plurality of battery banks during a predetermined time interval, and a second value, which is a standard deviation of a voltage variation amount per unit time for each of the plurality of battery banks, select the first value of each of the plurality of battery banks; rank the plurality of battery banks based on a first reference value, which represents a ratio of the selected first value of each of the plurality of battery banks to an average value of the selected first value of each of the plurality of battery banks; and diagnose at least one abnormal battery bank among the plurality of battery banks based on ranks of the plurality of battery banks at a designated time point.
According to some embodiments, when the first value of at least one battery bank among the plurality of battery banks is smaller than a value obtained by multiplying the second value of the at least one battery bank by a lower threshold value, the controller resets the first value without using the first value for diagnosing the abnormal battery bank.
According to some embodiments, when the first value of the at least one battery bank among the plurality of battery banks exceeds a value obtained by multiplying the second value of the at least one battery bank by an upper threshold value, the controller selects the first value to be used for diagnosing the abnormal battery bank.
According to some embodiments, when the first value of the at least one battery bank among the plurality of battery banks is equal to or more than the value obtained by multiplying the second value of the at least one battery bank by the lower threshold value, and is equal to or less than the value obtained by multiplying the second value of the at least one battery bank by the upper threshold value, the controller accumulates the first value of the at least one battery bank to diagnose the abnormal battery bank.

According to some embodiments, the controller calculates, as the first reference value, a ratio of the selected first value of each of the plurality of battery banks to a maximum value between the average value of the selected first value of each of the plurality of battery banks and the value obtained by multiplying the second value of each of the plurality of battery banks by the upper threshold value.

According to some embodiments, the controller ranks the plurality of battery banks in a descending order of the first reference value, and determines a battery bank ranked first to be a first battery bank, a battery bank ranked second to be a second battery bank, and a battery bank ranked last to be a third battery bank, among the plurality of battery banks.

According to some embodiments, the controller calculates a first deviation, which is a difference between the first reference value of the first battery bank and the first reference value of the second battery bank, calculates a second deviation, which is a difference between the first reference value of the second battery bank and the first reference value of the third battery bank, and based on a second reference value, which represents a ratio of the first deviation to the second deviation, diagnoses the abnormal battery bank at the designated time point.

According to some embodiments, when the first reference value of the first battery bank exceeds a first threshold value, and the second reference value of the first battery bank exceeds a second threshold value, the controller diagnoses the first battery bank as the abnormal battery bank.

According to some embodiments, a method for operating a battery management system comprises: measuring a voltage of each of the plurality of battery banks; calculating a first value, which is a variation amount of voltage of each of the plurality of battery banks during a predetermined time interval; calculating a second value, which is a standard deviation of a voltage variation amount per unit time for each of the plurality of battery banks; selecting the first value of each of the plurality of battery banks based on the first value and the second value of each of the plurality of battery banks; ranking the plurality of battery banks based on a first reference value, which represents a ratio of the selected first value of each of the plurality of battery banks to an average value of the selected first value of each of the plurality of battery banks; and diagnosing at least one abnormal battery bank among the plurality of battery banks based on ranks of the plurality of battery banks at a designated time point.

According to some embodiments, in the selecting, when the first value of at least one battery bank among the plurality of battery banks is smaller than a value obtained by multiplying the second value of the at least one battery bank by a lower threshold value, the first value is reset without being used for diagnosing the abnormal battery bank.

According to some embodiments, in the selecting, when the first value of the at least one battery bank among the plurality of battery banks exceeds a value obtained by multiplying the second value of the at least one battery bank by an upper threshold value, the first value is selected to be used for diagnosing the abnormal battery bank.

According to some embodiments, in the selecting, when the first value of the at least one battery bank among the plurality of battery banks is equal to or more than the value obtained by multiplying the second value of the at least one battery bank by the lower threshold value, and is equal to or less than the value obtained by multiplying the second value of the at least one battery bank by the upper threshold value, the first value is accumulated to diagnose the abnormal battery bank.

According to some embodiments, in the ranking, the first reference value is calculated as a ratio of the selected first value of each of the plurality of battery banks to a maximum value between the average value of the selected first value of each of the plurality of battery banks, and the value obtained by multiplying the second value of each of the plurality of battery banks by the upper threshold value.

According to some embodiments, in the ranking, the plurality of battery banks are ranked in a descending order of the first reference value, and among the plurality of battery banks, a battery bank ranked first is determined to be a first battery bank, a battery bank ranked second is determined to be a second battery bank, and a battery bank ranked last is determined to be a third battery bank.

According to some embodiments, in the diagnosing, a first deviation is calculated, which is a difference between the first reference value of the first battery bank and the first reference value of the second battery bank, a second deviation is calculated, which is a difference between the first reference value of the second battery bank and the first reference value of the third battery bank, and based on a second reference value, which represents a ratio of the first deviation to the second deviation, the first battery bank is diagnosed as the abnormal battery bank at the designated time point.

According to some embodiments, in the diagnosing, when the first reference value of the first battery bank exceeds a first threshold value, and the second reference value of the first battery bank exceeds a second threshold value, the first battery bank is diagnosed as the abnormal battery bank.

According to some embodiments, a controller for a battery management system comprises: a memory; and a processor coupled to the memory and configured to execute the method for operating a battery management system.

According to some embodiments, a non-transitory computer-readable storage medium has stored therein a program that causes an information processing apparatus to execute a process including: measuring a voltage of each of the plurality of battery banks; calculating a first value, which is a variation amount of voltage of each of the plurality of battery banks during a predetermined time interval; calculating a second value, which is a standard deviation of a voltage variation amount per unit time for each of the plurality of battery banks; selecting the first value of each of the plurality of battery banks based on the first value and the second value of each of the plurality of battery banks; ranking the plurality of battery banks based on a first reference value, which represents a ratio of the selected first value of each of the plurality of battery banks to an average value of the selected first value of each of the plurality of battery banks; and diagnosing at least one abnormal battery bank among the plurality of battery banks based on ranks of the plurality of battery banks at a designated time point.

According to some embodiments, in the diagnosing, a first deviation is calculated, which is a difference between the first reference value of the first battery bank and the first reference value of the second battery bank, a second deviation is calculated, which is a difference between the first reference value of the second battery bank and the first reference value of the third battery bank, and based on a second reference value, which represents a ratio of the first deviation to the second deviation, the first battery bank is diagnosed as the abnormal battery bank at the designated time point.

According to some embodiments, in the diagnosing, when the first reference value of the first battery bank exceeds a first threshold value, and the second reference value of the first battery bank exceeds a second threshold value, the first battery bank is diagnosed as the abnormal battery bank.

[DESCRIPTION OF DRAWINGS]

FIG. 1 is a view illustrating a battery pack according to an embodiment of the present disclosure.
FIG. 2 is a block diagram illustrating a configuration of a battery management system according to an embodiment of the present disclosure.
FIG. 3 is a flowchart illustrating an operation method of a battery management system according to an embodiment of the present disclosure.
FIG. 4 is a flowchart illustrating an operation of the battery management system and a method of diagnosing an abnormal battery bank according to an embodiment of the present disclosure.
FIG. 5 is a graph illustrating a voltage variation of each battery bank at predetermined time intervals during a relaxation time according to an embodiment of the present disclosure.
FIG. 6 is a graph illustrating a variation of a first value of each battery bank at predetermined time intervals according to an embodiment of the present disclosure.
FIG. 7 is a graph illustrating a variation of a second value of each battery bank at predetermined time intervals according to an embodiment of the present disclosure.
FIG. 8 is a graph illustrating a variation of a first reference value of each battery bank at predetermined time intervals according to an embodiment of the present disclosure.
FIG. 9 is a block diagram illustrating a hardware configuration of a computing system that implements an operation method of the battery management system according to an embodiment of the present disclosure.

[MODE FOR INVENTION]

Hereinafter, non-limiting examples of embodiments of the present disclosure will be described in detail with reference to the drawings. It is noted that the same components will be denoted by the same reference numerals even though they are illustrated in different drawings. When describing the embodiments herein, detailed description of related well-known configuration or a function thereof may be omitted if determined to impede the understanding of the embodiments.

In order to describe components of the embodiments, for example, terms such as "first," "second," "A," "B," "(a)," and "(b)" may be used. These terms are intended to simply discriminate a component from another without limiting the nature, sequence, or order of the component. Further, unless otherwise defined, all terms used herein, including technical and scientific terminologies, have the same meaning as commonly understood by those skilled in the art to which the embodiments of the present disclosure pertain. Terms such as those defined in commonly used dictionaries should be interpreted as having a meaning that is consistent with their meaning in the context of the relevant art, and should not be interpreted in an ideal or excessively formal sense unless clearly defined herein.

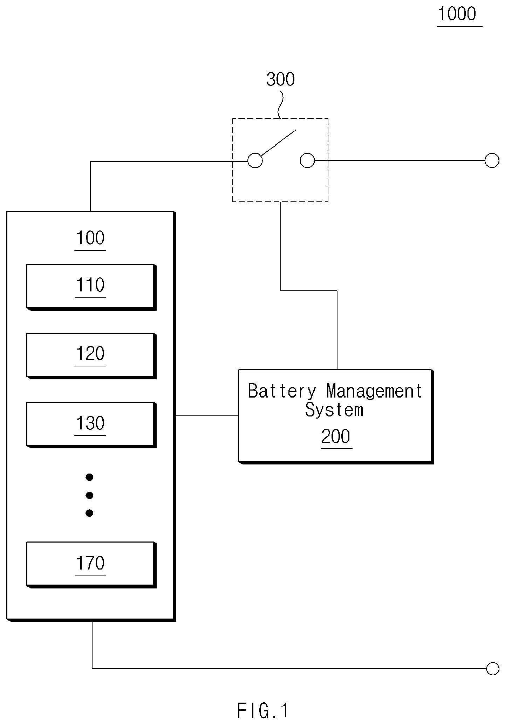

FIG. 1 is a view illustrating a battery pack 1000 according to an embodiment of the present disclosure. The battery pack 1000, for example, includes a battery module 100, a battery management system 200 (hereinafter, the "BMS 200"), and a relay 300. According to various embodiments, the battery module 100 may be battery cells. For example, the battery pack 1000 may have a cell-to-pack structure, in which battery cells are directly assembled into a pack without being divided into individual modules. This is unlike an existing battery, in which modules each consisting of battery cells are packaged.

While FIG. 1 illustrates one battery module 100, the battery pack 1000 may have a stacked structure of a plurality of battery modules. The battery module 100 may include a plurality of battery banks 110, 120, 130, 140, 150, 160, and 170 (hereinafter, the "battery banks 110 to 170"). While FIG. 1 illustrates seven battery banks, the number of battery banks is not limited thereto. The battery module 100 may include "n" battery banks ("n" is a natural number equal to or more than one).

The battery module 100 may supply power to a target apparatus (not illustrated). To this end, the battery module 100 may be electrically connected to the target apparatus. Here, the target apparatus may include an electrical, electronic, or mechanical apparatus that operates by receiving power from the battery pack 1000 including the battery module 100. For example, the target apparatus may be an electric vehicle (EV) or an energy storage system (ESS), but is not limited thereto.

Each of the battery banks 110 to 170 included in the battery module 100 may be made up of a single cell or a plurality of cells arranged either in series or in parallel. In an embodiment, the same number of cells may be connected to each other in series or in parallel in each battery bank.

According to an embodiment, the battery banks 110 to 170 may be electrically connected to each other in series or in parallel in the battery module 100, to configure a cell module assembly (CMA).

Each of the plurality of battery cells included in each of the battery banks 110 to 170 is a basic unit of a battery that can be used by charging/discharging the electrical energy, and may be, for example, but is not limited to, a lithium-ion (Li-ion) cell, a lithium-ion polymer (Li-ion polymer) cell, a nickel-cadmium (Ni-Cd) cell, or a nickel-hydride (Ni-MH) cell.

The BMS 200 may manage and/or control the state and/or operation of the battery module 100. For example, the BMS 200 may manage the charge and/or discharge of the battery banks 110 to 170 included in the battery module 100, and may manage and/or control the state and/or operation of the battery module 100.

Further, the BMS 200 may control the operation of the relay 300. For example, the BMS 200 may short-circuit the relay 300 in order to supply power to the target apparatus, and may also short-circuit the relay 300 when a charger is connected to the battery pack 1000.

The BMS 200 may monitor, for example, the voltage, current, and temperature of the battery module 100 and/or each of the battery banks 110 to 170 included in the battery module 100. For the monitoring by the BMS 200, sensors (not illustrated) or various measurement modules (not illustrated) may be additionally installed, for example, at arbitrary positions in the battery module 100 or charge/discharge pathways. The BMS 200 may calculate the parameters indicating the state of the battery module 100, such as a state of charge (SOC) or a state of health (SOH), based on measured values of the monitored voltage, current, temperature and others.

The battery banks 110 to 170 may go through changes of various internal factors over time and through repeated usages, resulting in decrease in capacity and increase in internal resistance. Based on the data of the various internal factors that change with the aging of the battery banks, the BMS 200 may diagnose an abnormality inside each of the battery banks 110 to 170.

In an embodiment, the BMS 200 uses voltage data of each of the battery banks 110 to 170 to diagnose an abnormal battery bank including, for example, a battery cell or battery bank suffering from a disconnection of an electrode tab, or a battery cell or battery bank suffering from a formation of lithium deposits in addition to the disconnection of an electrode tab. The formation of lithium deposits refers to a phenomenon wherein during the charge process of a battery cell, lithium ions from the anode are not chemically bonded to the cathode, instead remaining as metals on the surface of the cathode. In the case of a normal battery cell, lithium ions from the anode are reduced into the cathode during charge. However, in the case of a defective battery cell, some of lithium ions from the anode may be deposited as lithium metals on the surface of the cathode. When lithium byproducts grow due to the repeated formation of lithium deposits, the lithium byproducts may come into contact with the anode or the anode collector, causing an internal short between the cathode and the anode of the battery cell. The battery bank including the battery cell with the internal short self-discharges over time, and as a result, for example, the voltage may deviate from other normal battery banks.

The anode or cathode tab of a battery cell may be disconnected for various reasons such as, for example, defects in the manufacturing stage, internal deformation and degeneration through repeated charge/discharge operations, and external shock. In a case where the disconnection of an electrode tab and the formation of lithium deposits occur together in a battery cell, the electrode of the disconnected battery cell and the electrode of a normal battery cell may be connected to each other through the lithium deposits. Here, when the cathode of the disconnected battery cell has a higher SOC than the cathode of the normal battery cell, the cathodes of the two battery cells may come into contact with each other through the lithium deposits, and a charging may occur from the cathode of the disconnected battery cell to the cathode of the normal battery cell. Accordingly, a faster and more significant voltage variation may occur in the battery cell with the disconnection of an electrode tab and the formation of lithium deposits, in comparison to the normal battery cell.

The BMS 200 utilizes the phenomenon that the battery cell with the disconnection of an electrode tab and the formation of lithium deposits exhibits faster and more significant voltage variation during the relaxation time than normal battery cells. The BMS 200 may compare voltage data during the relaxation time of the battery cell with the disconnection of an electrode tab and the formation of lithium deposits, with statistical normal voltage data during the relaxation time of a normal battery cell, and identify (diagnose) the battery bank with the disconnection of an electrode tab and the formation of lithium deposits as an abnormal battery bank. The relaxation time of a battery cell or module refers to a state where the battery cell or module is not being currently charged or discharged, or is not electrically connected to a load. For example, the BMS 200 may monitor voltage values of cells or a charge/discharge current value of a battery module, to determine whether the cell or battery module is in the relaxation state.

The operation of the BMS 200 described herein below may be performed in various devices, such as a server, cloud, charger, or charger-discharger connected to the BMS 200 or a vehicle equipped with the BMS 200, through wired or wireless signals.

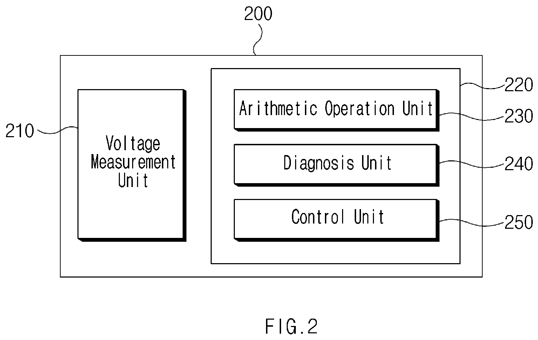

FIG. 2 is a block diagram illustrating the configuration of the BMS 200 according to an embodiment of the present disclosure.

The configuration of the BMS 200 may vary according to the environment of usage and purpose of the battery pack 1000 including the battery module 100, and may be equipped with many different operation units.

Referring to FIG. 2, the BMS 200 according to an embodiment of the present disclosure may include a voltage measurement unit 210 and a controller 220. The controller 220 may include an arithmetic operation unit 230, a diagnosis unit 240, and a control unit 250. In another embodiment, the BMS 200 may further include, for example, a current measurement unit and/or a temperature measurement unit, in addition to the voltage measurement unit 210.

The voltage measurement unit 210 is configured with a measurement device, such as a voltmeter, capable of measuring a voltage of a battery bank and/or a cell, and may measure the voltage of each of the battery banks 110 to 170 at predetermined time intervals to obtain time-series voltage data of each of the battery banks 110 to 170. In an embodiment, the voltage measurement unit 210 may calculate data of voltage rise and fall, and long-term relaxation data during charge, discharge, and relaxation time.

The arithmetic operation unit 230 performs various arithmetic operations for the diagnosis of an abnormal battery bank to be described below, by using the voltage data measured in the voltage measurement unit 210. The diagnosis unit 240 confirms, for example, whether the conditions to be described later are satisfied, by using the results of the arithmetic operations, and diagnoses an abnormal battery bank. Utilizing the result of the diagnosis, the control unit 250 may take appropriate measures for the abnormal battery bank, such as monitoring the defective battery bank and reporting to a user.

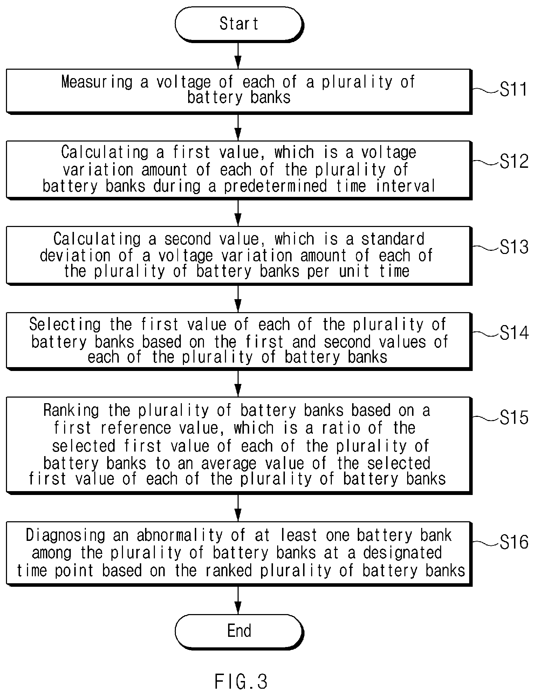

FIG. 3 is a flowchart illustrating an operation method of a battery management system according to an embodiment of the present disclosure.

Referring to FIG. 3, an operation method of a battery management system may comprise steps S11 to S16. According to an embodiment, an operation method of a battery management system may be performed by a battery management system 200.

In step S11, a battery management system 200 may measure a voltage of each of the plurality of battery banks. In step S12, a battery management system 200 may calculate a first value, which is a variation amount of voltage of each of the plurality of battery banks during a predetermined time interval. In step S13, a battery management system 200 may calculate a second value, which is a standard deviation of a voltage variation amount per unit time for each of the plurality of battery banks.

In step S14, a battery management system 200 may select the first value of each of the plurality of battery banks based on the first value and the second value of each of the plurality of battery banks. In step S15, a battery management system 200 may rank the plurality of battery banks based on a first reference value, which represents a ratio of the selected first value of each of the plurality of battery banks to an average value of the selected first value of each of the plurality of battery banks. In step S16, a battery management system 200 may diagnose at least one abnormal battery bank among the plurality of battery banks based on ranks of the plurality of battery banks at a designated time point.

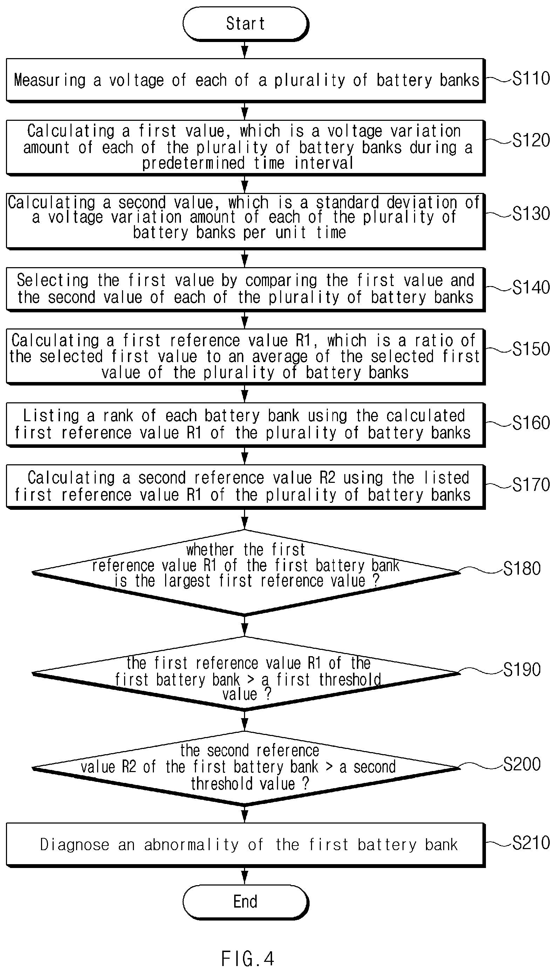

FIG. 4 is a flowchart illustrating an example operation of the BMS 200 and a method of diagnosing an abnormal battery bank according to an embodiment of the present disclosure.

Referring to FIG. 4, the operation method of the BMS 200 and the method of diagnosing an abnormal battery bank includes: measuring a first voltage of each of a plurality of battery banks at each of predetermined time intervals (S110); calculating a first value at each of the predetermined time intervals using the first voltage, wherein the first value is a voltage variation amount of the first voltage of each of the plurality of battery banks at each of the predetermined time intervals (S120); measuring a second voltage of each of the plurality of battery banks per unit time during each of the predetermined time intervals and calculating a second value at each of the predetermined time intervals using the second voltage, wherein the second value is a standard deviation of a voltage variation amount of the second voltage per unit time for each of the plurality of battery banks at each of the predetermined time intervals (S130); selecting (adjusting) the first value to be validated for each of the plurality of battery banks based on a comparison between the first and second values calculated at each of the predetermined time intervals (S140); calculating a first reference value R1 using a mathematical formula that represents a ratio of the selected first value to an average of the selected first value of each of the plurality of battery banks at each of the predetermined time intervals (S150); ranking the plurality of battery banks to first, second, and third battery banks at a designated time point based on the calculated first reference value R1 (S160); calculating a second reference value R2 using the calculated first reference value R1 and the ranking data (S170); determining whether the first reference value R1 of the first battery bank ranked at S160 is the largest first reference value R1 in the battery module 100 at the designated time point (S180); determining whether the first reference value R1 of the first battery bank is equal to or greater than a first threshold value at the designated time point (S190); determining whether the second reference value R2 is equal to or greater than a second threshold value at the designated time point (S200); and determining the first battery bank to be the abnormal battery bank at the designated time point (S210).

Hereinafter, the operation method of the BMS 200 and the method of diagnosing an abnormal battery bank will be described in more detail with reference to FIG. 4.

In step S110, the voltage measurement unit 210 may measure the voltage of each of the battery banks 110 to 170 at the predetermined time intervals during the relaxation time, and the controller 220 generates a graph representing the variation of the measured voltage of each of the battery banks 110 to 170.

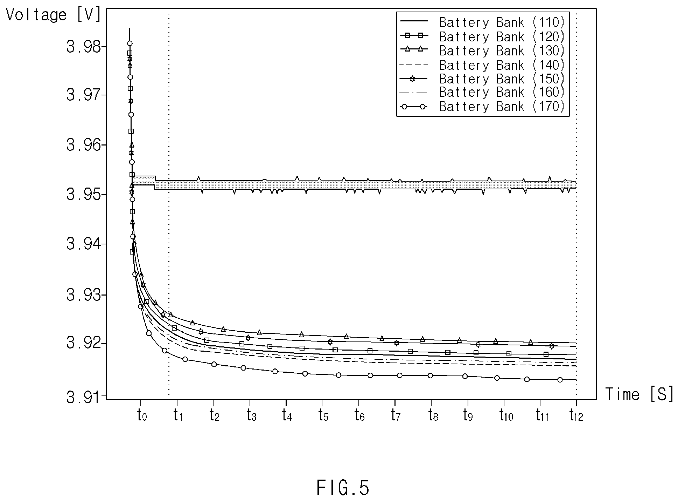

FIG. 5 is a graph illustrating the voltage measurements of the battery banks 110 to 170 at predetermined time points t1 to t12, spaced by intervals of 600 seconds from a time t0 when the relaxation time begins according to an embodiment of the present disclosure. That is, in the example of FIG. 5, the time t0 of the horizontal axis indicates the beginning of the relaxation time, and the time t12 indicates a time after a lapse of 7,200 seconds from the beginning of the relaxation time of t0. In general, the voltage of a battery bank or cell falls substantially within a relatively short time period (e.g., approximately 600 seconds) after the beginning of the relaxation time, and declines gradually thereafter. In the example of FIG. 5, the voltage of each of the battery banks 110 to 170 is around 3.98 V at the time t0 when the relaxation time begins, and sharply drops to around 3.92 V at the time t1 after a lapse of 600 seconds from the time t0. Referring to FIG. 5, the voltage measurement unit 210 may start measuring the voltage of each of the battery banks 110 to 170 at the time t1 which is after 600 seconds from the beginning of the relaxation time of t0. Subsequently, assuming that the predetermined interval is set to be 600 seconds, the voltage measurement unit 210 measures the voltage of each of the battery banks 110 to 170 at the time t2 which is after 600 seconds from t1. The voltage measurement unit 210 then measures the voltage of each of the battery banks 110 to 170 at the time t3 which is after 600 seconds from t2 (i.e., after 1,200 seconds from t1). Thereafter, the voltage measurement unit 210 may repeat measuring the voltage of each of the battery banks 110 to 170 at each time intervals, encompassing t4 through t12, and the controller 220 may generate a graph as illustrated in FIG. 5.

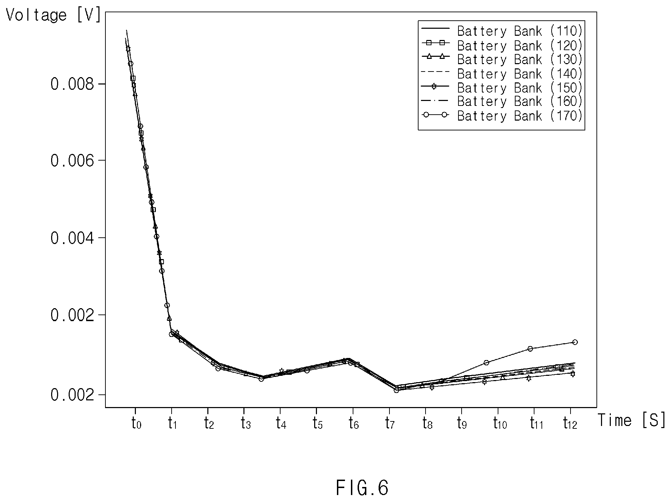

In step S120, the arithmetic operation unit 230 may calculate a first value $\Delta V$, which is the voltage variation amount of each of the battery banks 110 to 170 at two adjacent predetermined time intervals (e.g., 600 second), by using the voltage data measured in step S110. For example, referring to FIG. 6 which is a graph representing the first value $\Delta V$ of each battery bank according to an embodiment of the present disclosure, the arithmetic operation unit 230 may calculate the first value $\Delta V$ between t1 and t2, for example, by subtracting the voltage value at the time t2 from the voltage value at the time t1. That is, in an embodiment, the arithmetic operation unit 230 may compare the voltage of each of the battery banks 110 to 170 measured at the time of t1 when 600 seconds elapse after the beginning of the relaxation time, and the voltage of each of the battery banks 110 to 170 measured at the time t2 when 1,200 seconds elapse from the beginning of the relaxation time of t0, to calculate the first value $\Delta V$, which is the voltage variation amount of each of the battery banks 110 to 170 for 600 seconds. Subsequently, the arithmetic operation unit 230 plots the calculated first value $\Delta V$ at the time t2. The arithmetic operation unit 230 may repeat this process to calculate and plot the first value $\Delta V$ for each of the battery banks 110 to 170 at each of the times t3 to t12. In the graph of FIG. 6, the first value $\Delta V$ of the battery bank 170 is relatively high at the interval between t11 and t12, as compared to the other battery banks. From the graph, it is understood that the battery bank 170 may be an abnormal battery. In another embodiment, the predetermined time intervals may be set as 200 seconds, instead of 600 seconds, to calculate the voltage variation amount.

In step S130, the voltage measurement unit 210 and the arithmetic operation unit 230 may measure and calculate the voltage variation amount per unit time (e.g., 1 second) for each of the battery banks 110 to 170, and calculate a second value $\sigma dv$, which is the standard deviation "$\sigma$" of the voltage variation amount per unit time at the predetermined time intervals. For example, separately from step S110 described above, the voltage measurement unit 210 may measure the voltage of each of the battery banks 110 to 170 every second within 600 seconds of each predetermined time interval (e.g., from each of the timings t1 to t11 until its subsequent time). Subsequently, based on the measured voltage values per unit time, the arithmetic operation unit 230 may calculate the voltage variation amount and the second value $\sigma dv$, which is the standard deviation "$\sigma$" of the voltage variation amount for 1 second.

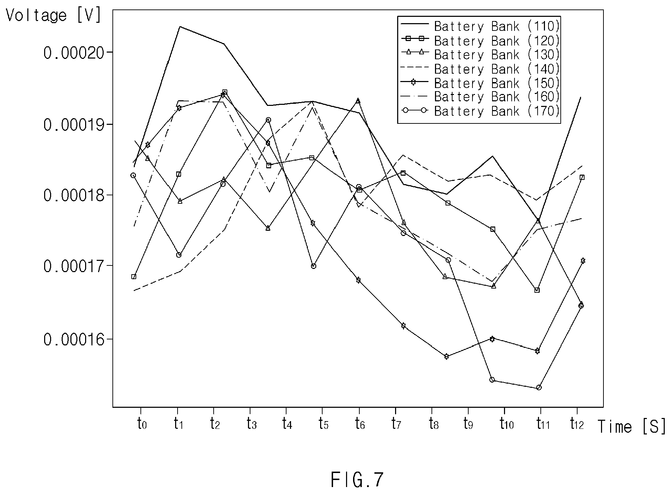

FIG. 7 is a graph representing the variation of the second value $\sigma dv$ calculated repeatedly at each of the predetermined time intervals of t2 to t12, for each of the battery banks 110 to 170 according to an embodiment of the present disclosure. For example, the arithmetic operation unit 230 may measure the voltage at every second within 600 seconds starting from the time t1 (e.g., when 600 seconds elapse from the beginning of the relaxation time) until the time t2 (e.g., when 1,200 seconds elapse from the beginning of the relaxation time), calculate the voltage variation amount per unit time and the standard deviation "$\sigma$" from the time t1 to t2, and plot the calculated standard deviation "$\sigma$" at the time t2. Subsequently, the arithmetic operation unit 230 may measure the voltage at every second within 600 seconds starting from the time t2 until the time t3 (e.g., when 1,800 seconds elapse from the beginning of the relaxation time), calculate the voltage variation amount per unit time and the standard deviation "$\sigma$" from the time t2 to t3, and plot the calculated standard deviation "$\sigma$" at the time t3. Then, the arithmetic operation unit 230 may measure the voltage at every second within 600 seconds starting from the time t3 until the time t4 (e.g., when 2,400 seconds elapse from the beginning of the relaxation time), calculate the voltage variation amount per unit time and the standard deviation "$\sigma$" from the time t3 to t4, and plot the calculated standard deviation "$\sigma$" at the time t4. The measuring, calculating, and plotting process may be repeated until the time t12 (e.g., when 7,200 seconds elapse from the beginning of the relaxation time), thereby generating a graph as illustrated in FIG. 7. In another embodiment, the voltage may be measured per unit time (e.g., every second) within 200 seconds of time intervals, instead of 600 seconds of time intervals, to calculate the second value σdv.

Meanwhile, since the calculation of the second value σdv may be performed separately from the calculation of the first value ΔV described above, the calculation of the second value σdv may be performed, for example, before the calculation of the first value ΔV.

In step S140, the arithmetic operation unit 230 may compare the first value ΔV and the second value σdv calculated at each of the time intervals of t2 to t12 for each of the battery banks 110 to 170, to select (adjust) the first value ΔV to be validated. Here, selecting (adjusting) the first value ΔV refers to determining whether the calculated first value ΔV is validated to be used for diagnosing (detecting) an abnormal battery bank according to the magnitude of the second value σdvj. In an embodiment, the second value σdv of each of the battery banks 110 to 170 is associated with a noise level used to determine whether the calculated first value ΔV of each of the battery banks 110 to 170 is a valid value or noise data. For example, the arithmetic operation unit 230 may compare the first value ΔV and the second value σdv of each of the battery banks 110 to 170 at each of the time intervals of t2 to t12, and determine the first value ΔV to be noise data that cannot be used for diagnosing an abnormal battery bank when, for example, the first value ΔV is equal to or less than a value calculated using the second value σdv. In this case, the arithmetic operation unit 230 may reset or initialize the first value ΔV.

As an example, assuming that the first value ΔV and the second value σdv of the battery bank 110 are 0.2 mV and 0.3 mV, respectively, at a given time (e.g., the time t3), and the lower threshold LT is set to be 1 (one), the first value ΔV of 0.2 mV at the given time would be less than 0.3 mV obtained by multiplying the second value σdv of 0.3 mV by the lower threshold LT of 1. Accordingly, the first value ΔV of 0.2 mV at the given time is determined to be noise data, and is reset or initialized without using it for the diagnosis of an abnormal battery bank.

In the meantime, when the first value ΔV of at least one of the battery banks 110 to 170 exceeds a value obtained by multiplying the second value σdv by an upper threshold UT, the arithmetic operation unit 230 may determine the first value ΔV of the corresponding battery bank to be useful for diagnosing an abnormal battery bank, and maintain the first value ΔV as valid data. For example, assuming that the first value ΔV and the second value σdv of the battery bank 110 are 0.7 mV and 0.3 mV, respectively, at a given time (e.g., the time t3) and the upper threshold UT is set to be 2 (two), the first value ΔV of 0.7 mV at the given time would be greater than 0.6 mV obtained by multiplying the second value σdv of 0.3 mV by the upper threshold UT of 2 (two). Accordingly, the first value ΔV of 0.7 mV at the given time is determined to be valid data, and is used for diagnosing an abnormal battery bank. That is, for example, the arithmetic operation unit 230 may determine the first value ΔV of 0.7 mV for the corresponding battery bank (e.g., the battery bank 110) at the given time (e.g., the time t3) to be the first value ΔV selected (validated) according to the second value σdv. According to an embodiment, the selected first value ΔV may be indicated by "dV" to be distinguished from the first value ΔV before the selection.

Meanwhile, when the first value ΔV of at least one of the battery banks 110 to 170 is equal to or greater than the value obtained by multiplying the second value σdv by the lower threshold LT and is equal to or less than the value obtained by multiplying the second value σdv by the upper threshold UT, the arithmetic operation unit 230 may accumulate the first value ΔV of the corresponding battery bank, and the accumulated first value ΔV may be used for diagnosing an abnormal battery bank at a later time. That is, for example, when the first value ΔV of the battery bank 110 is equal to or greater than the value obtained by multiplying the second value σdv by the lower threshold LT (e.g., 0.3 mV), and is equal to or less than the value obtained by multiplying the second value σdv by the upper threshold UT (e.g., 0.6 mV), the arithmetic operation unit 230 determines that the first value ΔV of the corresponding battery bank is not noise data but also inadequate for diagnosing an abnormal battery bank. Then, the arithmetic operation unit 230 may accumulate the first value ΔV of the corresponding battery bank over multiple time periods, and use the accumulated first value ΔV to diagnose an abnormal battery bank at a later time. Accordingly, the arithmetic operation unit 230 may recalculate the first value ΔV of each of the battery banks 110 to 170, add the recalculated first value ΔV to the previously stored first value ΔV, and compare the accumulated first value ΔV with the second value σdv again for a diagnosis.

In this way, the arithmetic operation unit 230 may compare the first value ΔV and the second value σdv of each of the battery banks 110 to 170, to reset the first value ΔV determined to be noise data or accumulate the first value ΔV over multiple time periods. Therefore, an unnecessary diagnosis process based on the noise data may not be performed, which prevents an excessive diagnosis of battery banks. Although not illustrated, the selected (adjusted) first value ΔV obtained by comparing the first value ΔV and the second value may be represented by a graph similar to FIG. 6.

In step S150, the arithmetic operation unit 230 may calculate an average value AVG_ΔV of the selected first value ΔV of each of the battery banks 110 to 170. Further, the arithmetic operation unit 230 may calculate a maximum value Max between the average value AVG_ΔV of the selected first value ΔV of each of the battery banks 110 to 170 and the value obtained by multiplying the second value σdv of each of the battery banks 110 to 170 by the upper threshold UT (e.g., 2).

Further, the arithmetic operation unit 230 may calculate the ratio of the selected first value ΔV of each of the battery banks 110 to 170 to the maximum value Max between the average value AVG_ΔV of the selected first value ΔV of each of the battery banks 110 to 170 and the value obtained by multiplying the second value σdv of each of the battery banks 110 to 170 by the upper threshold UT (e.g., 2), as the first reference value R1 of each of the battery banks 110 to 170 at the predetermined time intervals.

In an embodiment, the arithmetic operation unit 230 may calculate the first reference value R1 of each of the battery banks 110 to 170 using Equation 1 below.

[Equation 1]

$$\text{First Reference Value (R1)} = \frac{\text{First Value } (\Delta V)}{\text{Max}\left[\text{AVG}_{\Delta V},\ \text{Second Value}(\sigma_{dv}) * \text{UT}\right]}$$

As described above, the arithmetic operation unit 230 may use the Max function for the denominator of Equation 1 to calculate the first reference value R1. Specifically, the arithmetic operation unit 230 may use the Max function to input, into the denominator of Equation 1, the maximum value between the average value AVG_$\Delta V$ of the selected first value $\Delta V$ of each of the battery banks 110 to 170 and the value obtained by multiplying the second value $\sigma dv$ of each of the battery banks 110 to 170 by the upper threshold UT. By using the Max function for the denominator of Equation 1 as described above, the arithmetic operation unit 230 may make a setting such that the diagnosis of an abnormal battery bank is performed using the first reference value R1 only when the selected first value $\Delta V$ of a battery bank is somewhat greater than the noise level, e.g., when the selected first value $\Delta V$ is greater than the value obtained by multiplying the second value $\sigma dv$ by the upper threshold UT, thereby decreasing the number of unnecessary diagnosis processes.

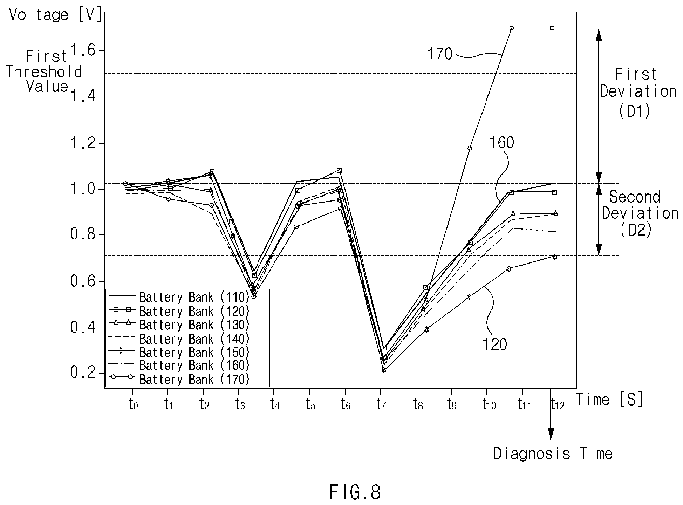

FIG. 8 is a graph illustrating the variation of the first reference value R1 of each battery bank according to an embodiment of the present disclosure.

In FIG. 8, the first reference value R1 calculated by the arithmetic operation unit 230 is plotted for each of the battery banks 110 to 170 at each of the predetermined time intervals of t2 to t12 (e.g., 600 seconds). The first reference value R1 is, for example, a value calculated by inputting the selected first value $\Delta V$ and the second value $\sigma dv$ of each of the battery banks 110 to 170 calculated by the arithmetic operation unit 230 at the intervals of 600 seconds (or 200 seconds), into Equation 1 as described above. Other aspects of FIG. 8 including the calculation of the second reference value R2 will be described herein below.

In step S160, the arithmetic operation unit 230 may rank the battery banks 110 to 170 either at each of the time intervals of t2 to t12 or at a designated time point (e.g., at t12), based on the calculated first reference value R1 of each of the battery banks 110 to 170. In the example of FIG. 8, assuming that the time t12 is designated as timing for the diagnosis, the arithmetic operation unit 230 may determine the battery bank 170 which has been ranked first with the largest first reference value R1 at the designated time t12 to be "a first battery bank B1," determine the battery bank 160 ranked second with the second largest first reference value R1 at the designated time t12 to be "a second battery bank B2," and determine the battery bank 110 ranked last with the smallest first reference value R1 at the designated time 12 to be "a third battery bank B3."

In step S170, the arithmetic operation unit 230 calculates the second reference value R2 using the first reference value R1 represented in FIG. 8 and Equation 2 below.

[Equation 2]

$$\text{Second Reference Value (R2)} = \frac{\text{First Deviation (D1)}}{\text{Second Deviation (D2)}} = \frac{(R1_{B1}) - (R1_{B2})}{(R1_{B2}) - (R1_{B3})}$$

That is, according to an embodiment, the arithmetic operation unit 230 may calculate, as the second reference value R2, a ratio of a first deviation D1 to a second deviation D2. As illustrate in FIG. 8, the first deviation D1 is a difference between a first reference value R1B1 of the first battery bank B1 determined to be a potential abnormal battery bank with the largest voltage variation amount based on the first reference value R1 at the time t12, and a first reference value R1B2 of the second battery bank B2 with the second largest voltage variation amount based on the first reference value R1 at the time t12. The second deviation D2 is a difference between a first reference value R1B2 of the second battery bank B2 and a first reference value R1B3 of the third battery bank B3 with the smallest voltage variation amount based on the first reference value R1.

When the first reference value R1 and the second reference value R2 are calculated as described above, the diagnosis unit 240 confirms whether the conditions described below are satisfied, to determine whether the first battery bank B1 with the largest first reference value R1 (e.g., the battery bank 170) is an abnormal battery bank.

In S180, the diagnosis unit 240 first confirms whether the first battery bank B1 (e.g., the battery bank 170) determined in step S160 has the largest first reference value R1 at the designated time point (e.g., t12) in the battery module 100 (first condition). In the example of FIG. 8, the battery bank 170 determined to be the first battery bank B1 exhibits the largest first reference value R1 in the battery module 100 at the designated time point t12.

In step S190, the diagnosis unit 240 confirms whether the first reference value R1 of the first battery bank B1 (e.g., the battery bank 170) is equal to or greater than a predetermined first threshold R1threshold at the designated time point of t12 (second condition). In the example of FIG. 8, the first reference value R1 of the battery bank 170 is greater than the predetermined first threshold R1threshold of 1.5.

In step S200, the diagnosis unit 240 confirms whether the second reference value R2 calculated above is greater than a predetermined second threshold R2threshold at the designated time point t12 (third condition). In the example of FIG. 8, at the time t12 for the designated diagnosis time, the first reference value R1 of the battery bank 170 is 1.75, the first reference value R1 of the battery bank 160 is 1.05, and the first reference value R1 of the battery bank 110 is 0.7. Accordingly, the second reference value R2 becomes 2 (two) (0.7/0.35), which is greater than the predetermined second threshold R2threshold of 1.

In step S210, when it is confirmed that all of the three conditions described above are satisfied at the time t12 for the diagnosis, the diagnosis unit 240 diagnoses the battery bank 170 determined to be the first battery bank B1 as an abnormal battery bank. That is, according to an embodiment, the diagnosis unit 240 may diagnose the battery bank 170 as an abnormal battery bank including a battery cell with the disconnection of an electrode tab or both the disconnection of an electrode tab and the formation of lithium deposits.

Then, as a measure of diagnosis, the control unit 250 may track and monitor whether the internal short occurs in the battery bank 170 which has been diagnosed as an abnormal battery bank, and further, may provide information on the battery bank 170 to the user. In an embodiment, the control unit 250 may provide, to a user terminal, the information on the battery bank 170 with the disconnection of an electrode tab or both the disconnection of an electrode tab and the formation of lithium deposits through a communication unit (not illustrated). Further, the control unit 250 may provide the information of the battery bank 170 using a display (not illustrated) mounted in, for example, a vehicle or a charger.

In case any of the conditions described in S180, S190, and S200 is not met at the designated time point t12, the process may return to S110 to continue the measuring and calculating. In another embodiment, the process may not return to S110 but return to any of the prior processes to continue the diagnosis.

As described above, according to the battery management system 200 of the embodiment described herein, it is possible to diagnose an abnormal battery bank including a battery cell with the disconnection of an electrode tab or both the disconnection of an electrode tab and the formation of lithium deposits, by using voltage behaviors of battery banks during the relaxation time.

Conventionally, the phenomenon of lithium deposits has been diagnosed using voltage data of a battery, in which lithium deposits are significantly formed, during the relaxation time after charge. However, the conventional method has a difficulty in determining the abnormality of voltage due to the marginal effect of the formed lithium deposits on the measured voltage of the battery.

In contrast, the battery management system 200 of the present disclosure may accurately diagnose an abnormal battery bank based on voltage variation amounts of a plurality of battery banks during a relaxation time, for example, by comparing the voltage variation amounts of the respective battery banks and ranking the battery banks according to the voltage variation amounts so as to analyze both of the short-term and long-term voltage behavior features of the battery banks.

The battery management system 200 of the present disclosure may diagnose a battery bank with the disconnection of an electrode tab and the formation of lithium deposits at an early stage by using the voltage variation amounts of battery banks, which ensures the safety and reliability of battery energy. Further, the battery management system 200 of the present disclosure may diagnose a battery bank with the disconnection of an electrode tab and the formation of lithium deposits even in a state where the battery is installed in a vehicle, so that an abnormal battery bank may be easily and quickly diagnosed without needing to be separated from the vehicle.

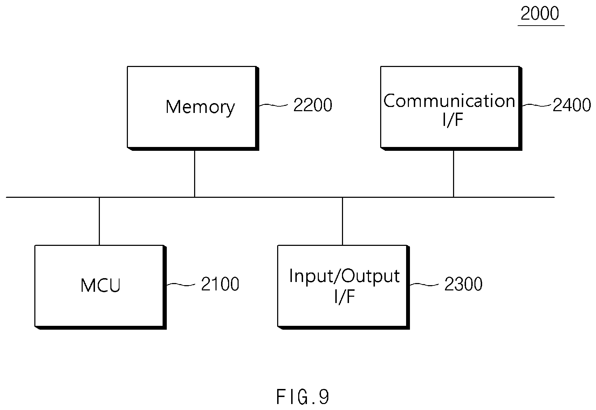

FIG. 9 is a block diagram illustrating a hardware configuration of a computing system that implements the operation method of the battery management system according to an embodiment of the present disclosure.

Referring to FIG. 9, a computing system 2000 according to an embodiment may include an MCU 2100, a memory 2200, an input/output I/F 2300, and a communication I/F 2400.

The MCU 2100 may be a processor that executes various programs stored in the memory 2200, processes various data used for the programs, and executes the functions of the BMS 200 illustrated in FIG. 1.

The memory 2200 may store various programs for implementing the operation of the BMS 200 and operation data of the BMS 200 for the diagnosis of the battery banks. As needed, a plurality of memories 2200 may be provided. Further, the memory 2200 may be a volatile memory or a nonvolatile memory. As for the volatile memory, the memory 2200 may be, for example, a RAM, a DRAM, or an SRAM. As for the nonvolatile memory, the memory 2200 may be, for example, a ROM, a PROM, an EAROM, an EPROM, an EEPROM, or a flash memory. The examples of the memory 2200 may not be limited to those described above.

The input/output I/F 2300 may connect the MCU 2100 with an input device (not illustrated) such as a keyboard, a mouse, or a touch panel, and an output device (not illustrated) such as a display, in order to transmit and receive data.

The communication I/F 2400 is configured to transmit and receive various data to/from a server, and may be any of various devices capable of supporting a wired or wireless communication. For example, through the communication I/F 2400, various programs or data for the voltage measurement and the abnormality diagnosis may be transmitted and received to/from a separate external server via either a wired communication or a wireless communication.

From the foregoing, it will be appreciated that various embodiments of the present disclosure have been described herein for purposes of illustration, and that various modifications may be made without departing from the scope and spirit of the present disclosure.

Accordingly, the embodiments disclosed herein merely illustrate the technical idea of the present disclosure without limiting the scope thereof. The protection scope of the present disclosure should be interpreted based on the scope indicated in the following claims, and other technical concepts equivalent to the scope of the claims should be construed as being included in the protection scope of the present disclosure.

[Description of Symbols]

1000: Battery Pack
100: Battery Module
110: Battery Bank-1
120: Battery Bank-2
130: Battery Bank-3
140: Battery Bank-4
150: Battery Bank-5
160: Battery Bank-6
170: Battery Bank-7
200: Battery Management Apparatus
210: Voltmeter
220: Controller
300: Relay
2000: Computing System
2100: MCU
2200: Memory
2300: Input/Output I/F
2400: Communication I/F
R1: First Value
R2: Second Value
D1: First Deviation

**Claims**

1.  A battery management system comprising:

    a voltmeter configured to measure a voltage of each of a plurality of battery banks; and
    a controller in communication with the voltmeter and configured to:

    based on a first value, which is a variation amount of voltage of each of the plurality of battery banks during a predetermined time interval, and a second value, which is a standard deviation of a voltage variation amount per unit time for each of the plurality of battery banks, select the first value of each of the plurality of battery banks;
    rank the plurality of battery banks based on a first reference value, which represents a ratio of the selected first value of each of the plurality of battery banks to an average value of the selected first value of each of the plurality of battery banks; and
    diagnose at least one abnormal battery bank among the plurality of battery banks based on ranks of the plurality of battery banks at a designated time point.

2. The battery management system according to claim 1,
wherein when the first value of at least one battery bank among the plurality of battery banks is smaller than a value obtained by multiplying the second value of the at least one battery bank by a lower threshold value, the controller resets the first value without using the first value for diagnosing the abnormal battery bank.

3. The battery management system according to claim 2,
wherein when the first value of the at least one battery bank among the plurality of battery banks exceeds a value obtained by multiplying the second value of the at least one battery bank by an upper threshold value, the controller selects the first value to be used for diagnosing the abnormal battery bank.

4. The battery management system according to claim 3,
wherein when the first value of the at least one battery bank among the plurality of battery banks is equal to or more than the value obtained by multiplying the second value of the at least one battery bank by the lower threshold value, and is equal to or less than the value obtained by multiplying the second value of the at least one battery bank by the upper threshold value, the controller accumulates the first value of the at least one battery bank to diagnose the abnormal battery bank.

5. The battery management system according to claim 4,
wherein the controller calculates, as the first reference value, a ratio of the selected first value of each of the plurality of battery banks to a maximum value between the average value of the selected first value of each of the plurality of battery banks and the value obtained by multiplying the second value of each of the plurality of battery banks by the upper threshold value.

6. The battery management system according to claim 5,
wherein the controller ranks the plurality of battery banks in a descending order of the first reference value, and determines a battery bank ranked first to be a first battery bank, a battery bank ranked second to be a second battery bank, and a battery bank ranked last to be a third battery bank, among the plurality of battery banks.

7. The battery management system according to claim 6,

   wherein the controller calculates a first deviation, which is a difference between the first reference value of the first battery bank and the first reference value of the second battery bank,
   calculates a second deviation, which is a difference between the first reference value of the second battery bank and the first reference value of the third battery bank, and
   based on a second reference value, which represents a ratio of the first deviation to the second deviation, diagnoses the abnormal battery bank at the designated time point.

8. The battery management system according to claim 7,
wherein when the first reference value of the first battery bank exceeds a first threshold value, and the second reference value of the first battery bank exceeds a second threshold value, the controller diagnoses the first battery bank as the abnormal battery bank.

9. A method for operating a battery management system, the method comprising:

   measuring a voltage of each of the plurality of battery banks;
   calculating a first value, which is a variation amount of voltage of each of the plurality of battery banks during a predetermined time interval;
   calculating a second value, which is a standard deviation of a voltage variation amount per unit time for each of the plurality of battery banks;
   selecting the first value of each of the plurality of battery banks based on the first value and the second value of each of the plurality of battery banks;
   ranking the plurality of battery banks based on a first reference value, which represents a ratio of the selected first value of each of the plurality of battery banks to an average value of the selected first value of each of the plurality of battery banks; and
   diagnosing at least one abnormal battery bank among the plurality of battery banks based on ranks of the plurality of battery banks at a designated time point.

**10.** The method for operating the battery management system according to claim 9,

wherein in the selecting,
when the first value of at least one battery bank among the plurality of battery banks is smaller than a value obtained by multiplying the second value of the at least one battery bank by a lower threshold value, the first value is reset without being used for diagnosing the abnormal battery bank.

**11.** The method for operating the battery management system according to claim 10,

wherein in the selecting,
when the first value of the at least one battery bank among the plurality of battery banks exceeds a value obtained by multiplying the second value of the at least one battery bank by an upper threshold value, the first value is selected to be used for diagnosing the abnormal battery bank.

**12.** The method for operating the battery management system according to claim 11,

wherein in the selecting,
when the first value of the at least one battery bank among the plurality of battery banks is equal to or more than the value obtained by multiplying the second value of the at least one battery bank by the lower threshold value, and is equal to or less than the value obtained by multiplying the second value of the at least one battery bank by the upper threshold value, the first value is accumulated to diagnose the abnormal battery bank.

**13.** The method for operating the battery management system according to claim 12,

wherein in the ranking,
the first reference value is calculated as a ratio of the selected first value of each of the plurality of battery banks to a maximum value between the average value of the selected first value of each of the plurality of battery banks, and the value obtained by multiplying the second value of each of the plurality of battery banks by the upper threshold value.

**14.** The method for operating the battery management system according to claim 13,

wherein in the ranking,
the plurality of battery banks are ranked in a descending order of the first reference value, and
among the plurality of battery banks, a battery bank ranked first is determined to be a first battery bank, a battery bank ranked second is determined to be a second battery bank, and a battery bank ranked last is determined to be a third battery bank.

**15.** The method for operating the battery management system according to claim 14,

wherein in the diagnosing,
a first deviation is calculated, which is a difference between the first reference value of the first battery bank and the first reference value of the second battery bank,
a second deviation is calculated, which is a difference between the first reference value of the second battery bank and the first reference value of the third battery bank, and
based on a second reference value, which represents a ratio of the first deviation to the second deviation, the first battery bank is diagnosed as the abnormal battery bank at the designated time point.

**16.** The method for operating the battery management system according to claim 15,

wherein in the diagnosing,
when the first reference value of the first battery bank exceeds a first threshold value, and the second reference value of the first battery bank exceeds a second threshold value, the first battery bank is diagnosed as the abnormal battery bank.

**17.** A controller for a battery management system, the controller comprising:

a memory; and

a processor coupled to the memory and configured to execute the method according to claim 9.

18. A non-transitory computer-readable storage medium having stored therein a program that causes an information processing apparatus to execute a process including:

measuring a voltage of each of the plurality of battery banks;
calculating a first value, which is a variation amount of voltage of each of the plurality of battery banks during a predetermined time interval;
calculating a second value, which is a standard deviation of a voltage variation amount per unit time for each of the plurality of battery banks;
selecting the first value of each of the plurality of battery banks based on the first value and the second value of each of the plurality of battery banks;
ranking the plurality of battery banks based on a first reference value, which represents a ratio of the selected first value of each of the plurality of battery banks to an average value of the selected first value of each of the plurality of battery banks; and
diagnosing at least one abnormal battery bank among the plurality of battery banks based on ranks of the plurality of battery banks at a designated time point.

19. The non-transitory computer-readable storage medium according to claim 18,

wherein in the diagnosing,
a first deviation is calculated, which is a difference between the first reference value of the first battery bank and the first reference value of the second battery bank,
a second deviation is calculated, which is a difference between the first reference value of the second battery bank and the first reference value of the third battery bank, and
based on a second reference value, which represents a ratio of the first deviation to the second deviation, the first battery bank is diagnosed as the abnormal battery bank at the designated time point.

20. The non-transitory computer-readable storage medium according to claim 19,

wherein in the diagnosing,
when the first reference value of the first battery bank exceeds a first threshold value, and the second reference value of the first battery bank exceeds a second threshold value, the first battery bank is diagnosed as the abnormal battery bank.

FIG.1

FIG.2

```
              ┌─────────────────────┐
              │        Start        │
              └─────────────────────┘
                         │
                         ▼
    ┌───────────────────────────────────────────┐
    │  Measuring a voltage of each of a plurality of │ ～S11
    │              battery banks                 │
    └───────────────────────────────────────────┘
                         │
                         ▼
    ┌───────────────────────────────────────────┐
    │  Calculating a first value, which is a voltage │ ～S12
    │   variation amount of each of the plurality of │
    │  battery banks during a predetermined time interval │
    └───────────────────────────────────────────┘
                         │
                         ▼
    ┌───────────────────────────────────────────┐
    │  Calculating a second value, which is a standard │ ～S13
    │  deviation of a voltage variation amount of each of │
    │    the plurality of battery banks per unit time │
    └───────────────────────────────────────────┘
                         │
                         ▼
    ┌───────────────────────────────────────────┐
    │  Selecting the first value of each of the plurality of │ ～S14
    │  battery banks based on the first and second values of │
    │      each of the plurality of battery banks │
    └───────────────────────────────────────────┘
                         │
                         ▼
    ┌───────────────────────────────────────────┐
    │  Ranking the plurality of battery banks based on a │ ～S15
    │   first reference value, which is a ratio of the │
    │   selected first value of each of the plurality of │
    │   battery banks to an average value of the selected │
    │  first value of each of the plurality of battery banks │
    └───────────────────────────────────────────┘
                         │
                         ▼
    ┌───────────────────────────────────────────┐
    │  Diagnosing an abnormality of at least one battery bank │ ～S16
    │   among the plurality of battery banks at a designated │
    │  time point based on the ranked plurality of battery banks │
    └───────────────────────────────────────────┘
                         │
                         ▼
              ┌─────────────────────┐
              │         End         │
              └─────────────────────┘
```

FIG.3

Start

Measuring a voltage of each of a plurality of battery banks — S110

Calculating a first value, which is a voltage variation amount of each of the plurality of battery banks during a predetermined time interval — S120

Calculating a second value, which is a standard deviation of a voltage variation amount of each of the plurality of battery banks per unit time — S130

Selecting the first value by comparing the first value and the second value of each of the plurality of battery banks — S140

Calculating a first reference value R1, which is a ratio of the selected first value to an average of the selected first value of the plurality of battery banks — S150

Listing a rank of each battery bank using the calculated first reference value R1 of the plurality of battery banks — S160

Calculating a second reference value R2 using the listed first reference value R1 of the plurality of battery banks — S170

whether the first reference value R1 of the first battery bank is the largest first reference value ? — S180

the first reference value R1 of the first battery bank > a first threshold value ? — S190

the second reference value R2 of the first battery bank > a second threshold value ? — S200

Diagnose an abnormality of the first battery bank — S210

End

FIG.4

FIG.5

FIG.6

FIG.7

FIG.8

2000

Memory ~ 2200

Communication I/F ~ 2400

MCU ~ 2100

Input/Output I/F ~ 2300

FIG.9

## INTERNATIONAL SEARCH REPORT

| | International application No. |
|---|---|
| | **PCT/KR2023/020464** |

| A. | CLASSIFICATION OF SUBJECT MATTER |
|---|---|

**G01R 31/392**(2019.01)i; **G01R 31/374**(2019.01)i; **G01R 31/385**(2019.01)i; **G01R 19/00**(2006.01)i; **G01R 19/165**(2006.01)i; **G01R 31/52**(2020.01)i; **G01R 19/10**(2006.01)i; **G01R 31/396**(2019.01)i; **B60R 16/033**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); G01R 19/00(2006.01); G01R 31/36(2006.01); G01R 31/367(2019.01); G01R 31/50(2020.01); H01M 10/44(2006.01); H02J 1/00(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전지(battery), 전압(voltage), 순위(rank), 뱅크(bank), 평균(average)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2022-0093843 A (LG ENERGY SOLUTION, LTD.) 05 July 2022 (2022-07-05) See paragraphs [0042]-[0060] and claims 1-9. | 1,9,17-18 |
| A | | 2-8,10-16,19-20 |
| Y | KR 10-2013-0028664 A (GS YUASA INTERNATIONAL LTD.) 19 March 2013 (2013-03-19) See claims 1-18. | 1,9,17-18 |
| Y | KR 10-2021-0141211 A (LG ENERGY SOLUTION, LTD.) 23 November 2021 (2021-11-23) See claims 1 and 9. | 1,9,17-18 |
| A | KR 10-2021-0050443 A (LG CHEM, LTD.) 07 May 2021 (2021-05-07) See claims 1-10. | 1-20 |
| A | US 2012-0175960 A1 (WINKELMAN, Robert) 12 July 2012 (2012-07-12) See entire document. | 1-20 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **18 March 2024** | **18 March 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/020464**

| Patent document cited in search report | | | Publication date (day/month/year) | Patent family member(s) | | | Publication date (day/month/year) |
|---|---|---|---|---|---|---|---|
| KR | 10-2022-0093843 | A | 05 July 2022 | CN | 116134325 | A | 16 May 2023 |
| | | | | EP | 4202457 | A1 | 28 June 2023 |
| | | | | JP | 2023-533238 | A | 02 August 2023 |
| | | | | US | 2023-0258735 | A1 | 17 August 2023 |
| | | | | WO | 2022-145998 | A1 | 07 July 2022 |
| KR | 10-2013-0028664 | A | 19 March 2013 | CN | 103001277 | A | 27 March 2013 |
| | | | | CN | 103001277 | B | 21 September 2016 |
| | | | | CN | 106329632 | A | 11 January 2017 |
| | | | | CN | 106329632 | B | 11 October 2019 |
| | | | | EP | 2568566 | A2 | 13 March 2013 |
| | | | | EP | 2568566 | A3 | 09 November 2016 |
| | | | | EP | 2568566 | B1 | 07 March 2018 |
| | | | | JP | 2013-070599 | A | 18 April 2013 |
| | | | | JP | 2016-225306 | A | 28 December 2016 |
| | | | | JP | 6032473 | B2 | 30 November 2016 |
| | | | | JP | 6217996 | B2 | 25 October 2017 |
| | | | | KR | 10-1956088 | B1 | 08 March 2019 |
| | | | | US | 2013-0063080 | A1 | 14 March 2013 |
| | | | | US | 2016-0013669 | A1 | 14 January 2016 |
| | | | | US | 9197080 | B2 | 24 November 2015 |
| | | | | US | 9722436 | B2 | 01 August 2017 |
| KR | 10-2021-0141211 | A | 23 November 2021 | CN | 114514433 | A | 17 May 2022 |
| | | | | EP | 4024066 | A1 | 06 July 2022 |
| | | | | EP | 4024066 | A4 | 07 December 2022 |
| | | | | JP | 2022-550154 | A | 30 November 2022 |
| | | | | JP | 7332084 | B2 | 23 August 2023 |
| | | | | US | 2022-0341997 | A1 | 27 October 2022 |
| | | | | WO | 2021-230533 | A1 | 18 November 2021 |
| KR | 10-2021-0050443 | A | 07 May 2021 | CN | 113795964 | A | 14 December 2021 |
| | | | | EP | 3988955 | A1 | 27 April 2022 |
| | | | | EP | 3988955 | A4 | 31 August 2022 |
| | | | | JP | 2022-537796 | A | 30 August 2022 |
| | | | | JP | 7302765 | B2 | 04 July 2023 |
| | | | | US | 2022-0179008 | A1 | 09 June 2022 |
| | | | | WO | 2021-085836 | A1 | 06 May 2021 |
| US | 2012-0175960 | A1 | 12 July 2012 | US | 2010-0259104 | A1 | 14 October 2010 |
| | | | | WO | 2010-120622 | A2 | 21 October 2010 |
| | | | | WO | 2010-120622 | A3 | 13 January 2011 |

Form PCT/ISA/210 (patent family annex) (July 2022)

**EP 4 621 428 A1**

**Patent documents cited in the description**

- KR 1020230172718
- KR 1020230047829
- KR 1020220182381